# EUROPEAN PATENT APPLICATION

(11) **EP 2 680 276 A1**
(43) Date of publication of application: **01.01.2014**
(21) Application number: 12749967.1
(22) Date of filing: 22.02.2012
(51) Int. Cl.: H01B 7/17, H01B 7/20, H02G 3/04

(54) **SHIELD CONDUCTOR**

(30) Priority: 25.02.2011 JP 2011040217
(71) Applicant: AutoNetworks Technologies, Ltd., Yokkaichi-shi, Mie 510-8503 (JP); Sumitomo Wiring Systems, Ltd., Yokkaichi-shi, Mie 510-8503 (JP); Sumitomo Electric Industries, Ltd., Osaka-shi Osaka 541-0041 (JP)
(72) Inventor: AOYAMA Naoki, Yokkaichi-shi Mie 510-8503 (JP); KUWAHARA Masanori, Yokkaichi-shi Mie 510-8503 (JP); SONODA Fujio, Yokkaichi-shi Mie 510-8503 (JP); ITANI Yasushi, Yokkaichi-shi Mie 510-8503 (JP); SUGIMOTO Yoshinori, Yokkaichi-shi Mie 510-8503 (JP); IZAWA Katsutoshi, Yokkaichi-shi Mie 510-8503 (JP)
(74) Representative: Winter, Brandl, Fürniss, Hübner, Röss, Kaiser, Polte - Partnerschaft
(86) International application number: PCT/JP2012/054214
(87) International publication number: WO 2012/115130

(57) **Abstract**

A shield conductor 10 includes an electric wire 11, a metal pipe 15, and a tubular protector 20. The protector 20 covers a portion extending from an end portion of the metal pipe 15 to an end portion of a casing 16. The protector 20 includes a tubular outer layer member 21 made of flexible insulation and a tubular flexible shield member 23 made of a conductive material. The outer layer member 21 is arranged to extend from a first connecting portion 23A to a second connecting portion 23B. The first connecting portion 23A is connected to the metal pipe 15 and the second connecting portion 23B is connected to the casing 16. The shield member 23 is arranged along an inner surface of the outer layer member 21 and provided integrally with the outer layer member 21. The shield member 23 is electrically connected to the metal pipe 15 at the first connecting portion 23A and is electrically connected to the casing 16 at the second connecting portion 23B.

## Description

### TECHNICAL FIELD

The present invention relates to a shield conductor.

### BACKGROUND ART

A shield conductor is mounted in a vehicle such as an electric vehicle and a hybrid vehicle to interconnect devices such as an inverter, a motor, and a battery. Such a shield conductor generally includes an electric wire and a shield member that covers a periphery of the electric wire. The electric wire is electrically connected to an equipment such as a connecting terminal provided in a casing. The shield member is electrically connected to the conductive casing at the end of the shield conductor.

The shield conductor may include a protector that protects the electric wire and the shield member together with a connecting portion connected to the casing (refer to Patent Document 1). The protector described in Patent Document 1 is a tubular member made of rubber. The tubular member is arranged outside the shield member that covers the periphery of the electric wire. An end portion of the tubular member covers a part of the casing.

In the shield conductor in Patent Document 1, the shield member is provided to the electric wire to block electromagnetic wave generating from the electric wire. The protector is provided to protect the electric wire and the shield member.

The shield conductor in Patent Document 1 includes a tubular braided wire that is made by interweaving metal wires in mesh. The braided wire is provided as the shield member. The end of such a braided wire may be connected to a metal pipe that blocks electromagnetic wave generating from the electric wire and protects the electric wire (refer to Patent Document 2).

### RELATED ART DOCUMENT

### Patent Document

Patent Document 1: Japanese Unexamined Patent Publication No. 2006-313698
Patent Document 2: Japanese Unexamined Patent Publication No. 2004-171952

### DISCLOSURE OF THE PRESENT INVENTION

### Problem to be Solved by the Invention

In the above-described shield conductor, the braided wire, the metal pipe, and the protector need to be attached to the electric wire in this sequence in the attachment work of the members for the electromagnetic shielding and the wire protection. This attachment work is troublesome in the conventional shield conductor.

The present invention was accomplished in view of the foregoing circumstances. An object of the present invention is to provide a shield conductor that simplifies attachment of electromagnetic shielding and wire protection members.

### Means for Solving the Problem

To solve the above problem, a shield conductor according to the present invention includes an electric wire, a metal pipe, and a tubular protector. The electric wire is configured to be connected to a device provided in a casing. The metal pipe surrounds the electric wire. The tubular protector covers a portion of the electric wire extending from an end portion of the metal pipe to an end portion of the casing. The protector includes a tubular outer layer member and a tubular flexible shield member. The outer layer member is arranged to extend from a first connecting portion to a second connecting portion. The outer layer member is made of flexible insulation. The first connecting portion is connected to the metal pipe and the second connecting portion is configured to be connected to the casing. The tubular flexible shield member is arranged along an inner surface of the outer layer member and provided integrally with the outer layer member. The shield member is made of a conductive material and electrically connected to the metal pipe at the first connecting portion of the protector and configured to be electrically connected to the casing at the second connecting portion of the protector.

According to the present invention, electromagnetic shielding and electric wire protection members are attached as follows. First, the tubular protector is attached to the end portion of the metal pipe. Next, the electric wire is inserted through the metal pipe and then connected to the device provided in the casing. Then, the protector is fitted to the end portion of the casing to which the electric wire is connected. Consequently, the protector is arranged extending from the end portion of the metal pipe to the end portion of the casing. According to the present invention, the tubular protector covers the portion of the electric wire extending from the end portion of the metal pipe to the end portion of the casing. The protector includes the tubular outer layer member and the tubular flexible shield member. The outer layer member is arranged to extend from the first connecting portion to the second connecting portion. The outer layer member is made of flexible insulation. The first connecting portion is connected to the metal pipe and the second connecting portion is configured to be connected to the casing. According to the present invention, the electric wires including the connecting portion connected to the device can be protected only by fitting the protector to the electric wires that are connected to the device in the casing and passed through the metal pipe. Further, according to the present invention, only by attaching the protector to the electric wires, the electrical connection is established between the first connecting portion of the shield member and the metal pipe and between the second connecting portion of the shield member and the casing. The shield member is made of a conductive material and provided integrally with the inner surface of the outer layer member of the protector. This simplifies a work of attaching a member for the electromagnetic shielding and electric wire protection.

The present invention may have a following configuration.
The shield conductor may further include a tubular inner layer member made of flexible insulation. The inner layer member is provided on an inner surface of the shield member excluding parts of the inner surface of the shield member corresponding to the first connecting portion and the second connecting portion. The inner layer member and the outer layer member sandwich the shield member so as to be integral with each other.
With this configuration, because the shield member is less likely to catch on the electric wire or a terminal connected to the electric wire. Therefore, the protector can be easily attached and the inner surface of the shield member can be protected.

A first fixing member is fitted to a portion of a protector corresponding to the first connecting portion so as to fix the protector to the metal pipe. A second fixing member is fitted to a portion of the protector corresponding to the second connecting portion so as to fix the protector to the casing. With this configuration, the electrical connection between the shield member and the metal pipe and between the shield member and the casing can be ensured.

At least one of the first and the second fixing members may be provided on the inner surface of the shield member of the protector. With this configuration, the protector and the fixing members can be provided as a single member.

The outer layer member may be made of rubber. With this configuration, the first connecting portion is pressed to the end portion of the metal pipe due to the elasticity of the outer layer member and the connection between the shield member and the metal pipe can be secured. The second connecting portion is pressed to the end portion of the casing due to the elasticity of the outer layer member and the connection between the shield member and the casing can be secured.

The inner layer member may be made of rubber. With this configuration, the connection between the protector and the metal pipe and between the protector and the casing can be secured.

### Advantageous Effect of the Invention

The present invention provides a shield conductor that simplifies a work of attaching members for electromagnetic shielding and electric wire protection.

### BRIEF DESCRIPTION OF THE DRAWINGS

FIG. 1 is a side view of a shield conductor according to a first embodiment.
FIG. 2 is a cross-sectional view taken along line X-X in FIG. 1.
FIG. 3 is a cross-sectional view of the shield conductor.
FIG. 4 is a cross-sectional view of a clamp band (a fixing member).
FIG. 5 is a cross-sectional view of the shield conductor prior to fixing the fixing member.
FIG. 6 is a side view of a shield conductor according to a second embodiment.
FIG. 7 is a cross-sectional view taken along line Y-Y in FIG. 6.
FIG. 8 is a cross-sectional view of the shield conductor.
FIG. 9 is a perspective view of a C-ring (a fixing member).
FIG. 10 is a cross-sectional view of the shield conductor before the fixing member is fixed.
FIG. 11 is a cross-sectional view of a shield conductor explained in another embodiment (1).
FIG. 12 is a cross-sectional view of a shield conductor explained in other embodiment (2).
FIG. 13 is a cross-sectional view of the shield conductor before the fixing member is fixed in FIG. 12.

### MODE FOR CARRYING OUT THE INVENTION

### <First embodiment>

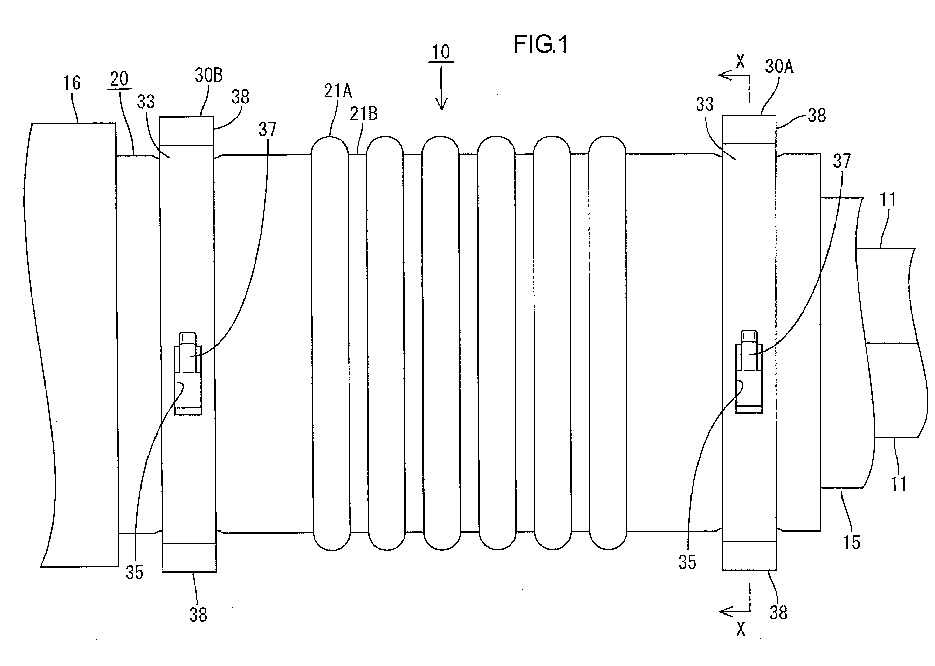

A first embodiment of the present invention will be described with reference to FIGS. 1 to 5. As illustrated in FIG. 1, a shield conductor 10 in this embodiment includes electric wires 11, a metal pipe 15, and a tubular protector 20. The electric wires 11 are connected to a device (not illustrated) housed in a casing 16 of an electric component. The metal pipe 15 covers peripheries of the electric wires 11. The protector 20 covers a portion of the electric wires 11 extending from an end portion of the pipe 15 to an end portion of the casing 16 when the protector 20 is connected to the casing 16.

Because the electric wires 11 are surrounded by the metal pipe 15 and the protector 20, electromagnetic waves from the electric wires 11 are shielded. The shield conductor 10 is installed in a vehicle such as an electric vehicle and a hybrid vehicle (not illustrated) to interconnect electric components such as a battery (not illustrated), an inverter (not illustrated), and a motor (not illustrated).

### (Electric wire 11)

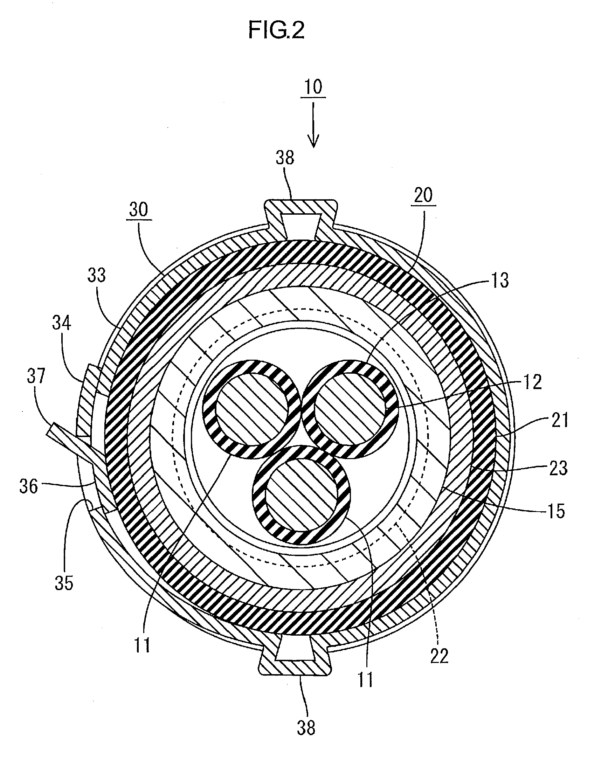

As illustrated in FIG. 2, three electric wires 11 are passed through inside the metal pipe 15 and inside the protector 20 and arranged in a triangle (the electric wires 11 are arranged such that lines connecting the centers of the electric wires 11 form a substantially regular triangle). Each electric wire 11 includes a core wire 12 and wire insulation 13. The core wire 12 has a circular cross-sectional shape and is made of metal (e.g. copper, copper alloy, aluminum, aluminum alloy, stainless). The wire insulation 13 covers an outer periphery of the core wire 12. The core wire 12 may be a rod-shaped single core wire or may be a stranded wire made of a plurality of metal thin wires that are twisted one another. A terminal connector, which will not be explained in detail, is provided at an end of the electric wire 11 and electrically connected to the device provided in the casing 16. The casing 16 is made of metal (conductor) such as aluminum and stainless.

### (Metal pipe 15)

As illustrated in FIG. 2, the metal pipe 15 has a circular cross-sectional shape and has a constant thickness over its entire circumference. Namely, an inner circumference and an outer circumference of the metal pipe 15 are concentric circles. An outer surface of the metal pipe 15 is smooth and curved.

The metal pipe 15 can be made of any metal such as aluminum, aluminum alloy, iron, stainless, copper, and copper alloy as necessary. The metal pipe 15 is made of aluminum or aluminum alloy in this embodiment. If the metal pipe 15 is made of iron, an antirust process may be applied to an inner surface and the outer surface of the metal pipe 15. Any antirust process such as galvanization and film coating may be applied as necessary.

### (Protector 20)

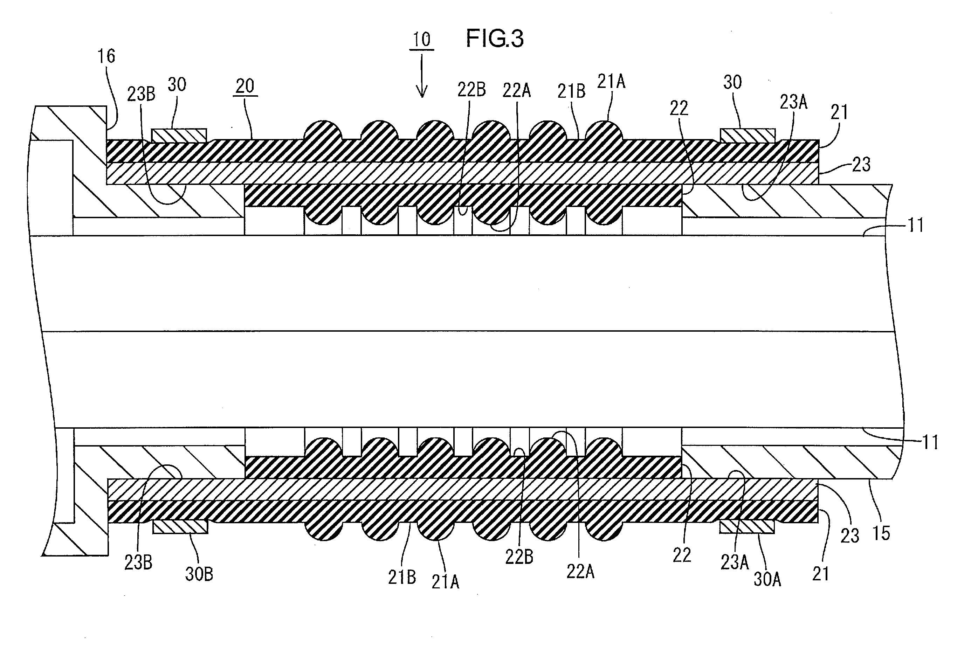

As illustrated in FIG. 3, the protector 20 is arranged to cover the portion of the electric wires 11 extending from the end portion of the metal pipe 15 to the end portion of the casing 16. The protector 20 includes an outer layer member 21, an inner layer member 22, and a shield member 23. The outer layer member 21 configures an outer surface of the protector 20. The inner layer member 22 configures an inner surface of the protector 20. The shield member 23 is provided between the outer layer member 21 and the inner layer member 22.

Each of the outer layer member 21 and the inner layer member 22 is formed in a tubular shape and is made of rubber such as fluorine-contained rubber, silicone rubber, and acrylic rubber.

The outer layer member 21 is arranged such that one end portion (a right end portion in FIG. 3) of the outer layer member 21 overlaps the end portion of the metal pipe 15 and another end portion (a left end portion in FIG. 3) of the outer layer member 21 overlaps the end portion of the casing 16. The outer layer member 21 has an outer surface between the one end portion and the other end portion that is formed in a wavy shape. Namely, projection portions 21A and recess portions 21B are formed alternately and repeatedly. With such a configuration, the outer layer member 21 is easily bent.

The shield member 23 is configured with a braided wire that is made by interweaving metal wires in mesh. The shield member 23 has one end portion 23A (a right end portion 23A in FIG. 3) and another end portion 23B (a left end portion 23B in FIG. 3). The one end portion 23A is fitted to the metal pipe 15 together with the outer layer member 21 from an outer side and electrically connected to the metal pipe 15. The other end portion 23B is fitted to the casing 16 together with the outer layer member 21 from the outer side and electrically connected to the casing 16. The one end portion 23A of the shield member 23 that is connected to the metal pipe 15 is a first connecting portion 23A. The other end portion 23B of the shield member 23 that is connected to the casing 16 is a second connecting portion 23B. The shield member 23 that is configured with the braided wire has high flexibility that enables any deformations such as bending with curving, stretching in a longitudinal direction, and changes in a diameter.

The metal wires of the shield member 23 may be made of any one of aluminum, aluminum alloy, iron, stainless, copper, and copper alloy as necessary. In this embodiment, copper or copper alloy is used. A plated layer may be applied to a surface of the metal wire. The plated layer may be configured with any metal such as tin, nickel, chromium as necessary. The shield member 23 may also be a tubular conductive film made of copper or aluminum.

As illustrated in FIG. 3, the inner portion 22 is provided in a tubular shape and along a part of an inner surface of the shield member 23 excluding the first connecting portion 23A, at which the outer layer member 21 and the shield member 23 are connected to the metal pipe 15, and the second connecting portion 23B, at which the outer layer member 21 and the shield member 23 are connected to the casing 16. Similar to the outer layer member 21, the inner surface of the inner layer member 22 is formed in a wavy shape and projection portions 22A and recess portions 22B are formed alternately and repeatedly.

### (Fixing member 30)

Clamp bands 30 made of metal are fitted to a portion of the protector 20 corresponding to the first connecting portion 23A and a portion of the protector 20 corresponding to the second connection portion 23B. A clamp band 30A is fitted to and clamps the portion of the protector 20 corresponding to the first connecting portion 23A, and accordingly, the protector 20 is fixed to the metal pipe 15. This surely establishes electrical connection between the metal pipe 15 and the shield member 23. Similarly, a clamp band 30B is fitted to and clamps the portion of the protector 20 corresponding to the second connecting portion 23B, and accordingly, the protector 20 is fixed to the casing 16. This surely establishes electrical connection between the casing 16 and the protector 20. The clamp band 30A that is fitted to and clamps the first connecting portion 23A is a first clamp band 30A (an example of a first fixing member). The clamp band 30B that is fitted to and clamps the second connecting portion 23B is a second clamp band 30B (an example of a second fixing member). The first and the second clamp bands 30A and 30B are collectively referred to as the clamp bands 30.

Each clamp band 30 is configured with a band member 33 made of a belt-like metal plate. Two end portions of the band member 33 are overlapped each other and the band member 33 is formed into a ring-like shape. One of the two end portions of the band member 33 that is located on a radial outer side in the overlapped portion is an outer band portion 34. The outer band portion 34 has a through hole 35. The other one of the two end portions of the band member 33 that is located on a radial inner side in the overlapped portion is an inner band portion 36. The inner band portion 36 has a stopper 37. The stopper 37 is formed by cutting in the inner band portion 36 and lifting up the cut portion radially outward. The stopper 37 is inserted through the through hole 35 in the outer band portion 34 and stopped by a peripheral edge of the through hole 35. As a result, the clamp band 30 maintains its ring-like shape.

The band member 33 further has clamp portion 38. Each clamp portion 38 is formed by bending the band member 33 in a gate-like shape so as to protrude radially outward. The two clamp portions 38 are located substantially in opposite end portions on the diameter of the band member 33. The clamp portions 38 are clamped by a known jig to be pressed such that the diameter of the band member 33 is decreased. If the band member 33 is deformed by decreasing its diameter, the outer layer member 21, the shield member 23, and the metal pipe 15 that are located on a radial inner side of the first clamp band 30A are firmly fixed to each other in a portion of the protector 20 corresponding to the first connecting portion 23A. If the band member 33 is deformed by decreasing its diameter, the outer layer member 21, the shield member 23, and the casing 16 that are located on a radial inner side of the second clamp band 30B are firmly fixed to each other in a portion of the protector 20 corresponding to the second connecting portion 23B.

### (A process of manufacturing the shield conductor 10)

A process of manufacturing the shield conductor 10 according to the present embodiment will be explained hereinafter. The process of manufacturing the shield conductor 10 is not limited to the following process.

First, the inner side surfaces of the two end portions of the tubular shield member 23 (portions corresponding to the first connecting portion 23A and the second connecting portion 23B) are masked. Then, the shield member 23 is molded such that the outer layer member 21 and the inner layer member 22 made of rubber are formed on the outer and the inner surfaces of the shield member 23. This provides the protector 20 having the portions of the inner surfaces of the shield member 23 corresponding to the first and the second connecting portions 23A and 23B are exposed (without having the inner layer member 22 made of rubber). Another method of forming the shield member 23 without having the inner layer member 22 in the end portions 23A and 23B is, for example, as follows. After the outer layer member 21 and the inner layer member 22 are formed over entire areas of the outer and inner surfaces of the shield member 23, the inner layer member 22 formed in the end portion on the inner surface is scraped off with a knife.

Then, the electric wires 11 are passed through the metal pipe 15 and the obtained protector 20. After the electric wires 11 are connected to the device arranged in the casing 16, the protector 20 is fitted over the end portion of the casing 16 in which the electric wires 11 are connected to the device. Consequently, the protector 20 is arranged so as to extend from the end portion of the pipe 15 to the end portion of the casing 16.

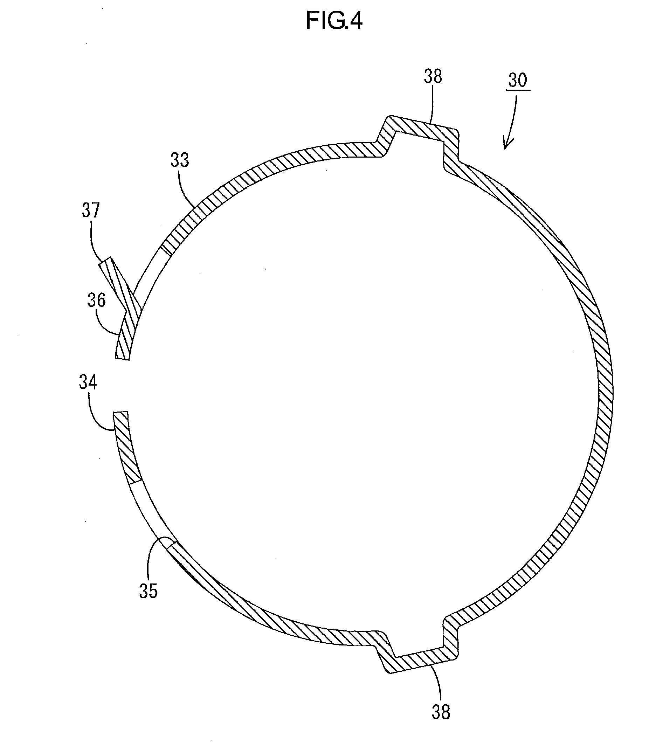

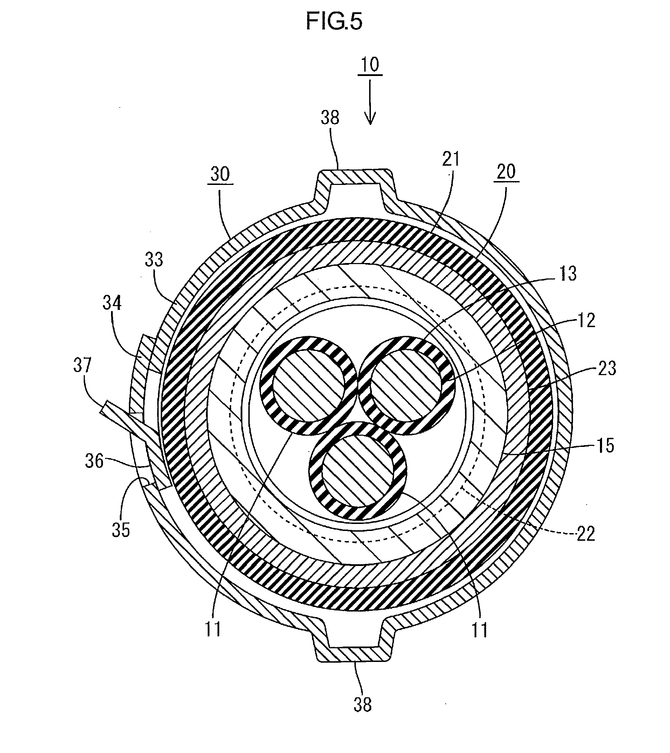

Next, the first clamp band 30A is fitted to a portion of the outer surface of the protector 20 corresponding to the first connecting portion 23A, and the second clamp band 30B is fitted to a portion of the outer surface of the protector 20 corresponding to the second connecting portion 23B. As illustrated in FIG. 4, each clamp band 30 is prepared to have a gap between the two end parts of the band member 33. This improves workability of fitting the clamp band 30 to the outer surface of the protector 20. After the band member 33 is arranged around the outer surface of the protector 20, the two end parts of the band member 33 are overlapped. Then, the stopper 37 of the inner band portion 36 is passed through the through hole 35 of the outer band portion 34. As illustrated in FIG. 5, the stopper 37 is stopped by the peripheral edge of the through hole 35 and the band member 33 maintains its ring-like shape. FIG. 5 illustrates the shield conductor 10 before clamping the metal pipe 15 with the first clamp band 30A. The shield conductor 10 before clamping the casing 16 with the second clamp band 30B also has a similar configuration to that is illustrated in FIG. 5.

Next, the clamp portions 38 of the first clamp band 30A are pressed and deformed by a known jig. This deformation decreases the diameter of the band member 33 and the protector 20 and the metal pipe 15 are firmly fixed to each other by the first clamp band 30 (refer to FIG. 2). Similarly, the clamp portions 38 of the second clamp member 30B are pressed and deformed by a known jig. This deformation decreases the diameter of the band member 33 and thus the protector 20 and the casing 16 are firmly fixed to each other by the second clamp band 30. In such a state, the inner surface of the shield member 23 is in contact with the outer surface of the metal pipe 15 and the outer surface of the casing 16. Accordingly, the shield member 23 is electrically connected to the metal pipe 15 in the first connecting portion 23A and electrically connected to the casing 16 in the second connecting portion 23B. FIG. 2 illustrates the shield conductor 10 after clamping the metal pipe 15 with the first clamp band 30A. The shield conductor 10 after clamping the casing 16 with the second clamp band 30B also has a similar configuration to that in FIG. 2.

### (Operations and effects)

The operations and the effects of the present embodiment will be explained.
In the present embodiment, the protector 20 includes the tubular outer layer member 21 made of flexible insulation and the tubular flexible shield member 23 made of a conductive material. The outer layer member 21 is arranged to extend from the first connecting portion 23A to the second connecting portion 23B. The first connecting portion 23A is connected to the metal pipe 15 and the second connecting portion 23B is connected to the casing 16. The shield member 23 is provided on the inner surface of the outer layer member 21 so as to be integral with each other. According to the present embodiment, the electric wires 11 including the connecting portion connected to the device can be protected only by fitting the protector 20 to the electric wires 11 that are connected to the device in the casing 16 and passed through the metal pipe 15. Further, according to the present embodiment, only by attaching the protector 20 to the electric wires 11, the electrical connection is established between the first connecting portion 23A of the shield member 23 and the metal pipe 15 and between the second connecting portion 23B of the shield member 23 and the casing 16. The shield member 23 is made of a conductive material and provided integrally with the inner surface of the outer layer member 21 of the protector 20. This simplifies a work of attaching a member for the electromagnetic shielding and electric wire protection.

According to the present embodiment, the tubular inner layer member 22 made of flexible insulation is provided to integrally sandwich the shield member 23 with the outer layer member 21. The inner layer member 22 is arranged on the inner surface of the shield member 23 excluding the inner surfaces of the shield member 23 corresponding to the first and the second connecting portions 23A and 23B. With such a configuration, the shield member 23 is less likely to catch on the electric wires 11 or a terminal connected to the electric wires 11. Therefore, the protector 20 can be easily attached and the inner surface of the shield member 23 can be protected.

According to the present embodiment, the first clamp band 30A and the second clamp band 30B are fitted to the portions of the protector 20 corresponding to the first connecting portion 23A and the second connecting portion 23B, respectively. This ensures the electrical connection between the shield member 23 and the metal pipe 15 and between the shield member 23 and the casing 16. Further, according to the present embodiment, the protector 20 can be easily fixed to the metal pipe 15 and the casing 16 by clamping and pressing the clamp portions 38 of the clamp bands 30.

Further, according to the present embodiment, the outer layer member 21 is made of rubber. Therefore, the first connecting portion 23A is pressed to the end portion of the metal pipe 15 due to the elasticity of the outer layer member 21 and the connection between the shield member 23 and the metal pipe 15 can be secured. The second connecting portion 23B is pressed to the end portion of the casing 16 due to the elasticity of the outer layer member 21 and the connection between the shield member 23 and the casing 16 can be secured.

According to the present embodiment, the inner layer member 22 is also made of rubber, and this ensures the connection between the protector 20 and the metal pipe 15 and the connection between the protector 20 and the casing 16.

### <Second embodiment>

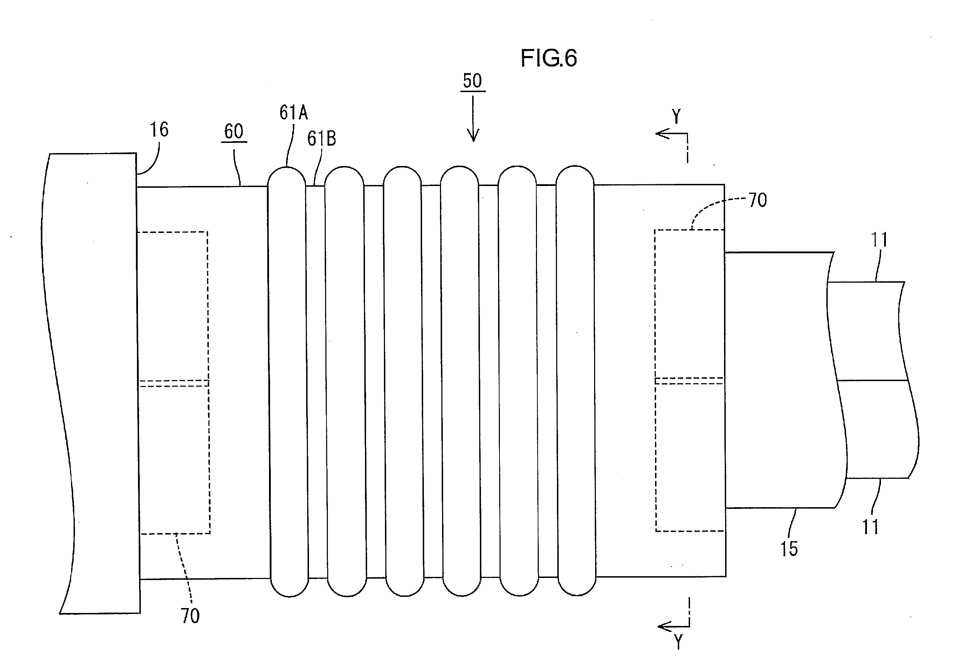

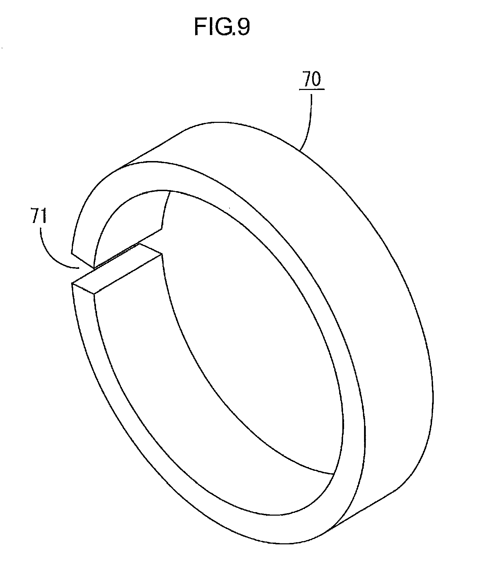

A second embodiment of the present invention will be described with reference to FIGS. 6 to 10. As illustrated in FIGS. 6 to 8, a shield conductor 50 of the second embodiment differs from that of the first embodiment in that the shield conductor 50 includes substantially C-shaped C-rings 70 that are provided on an inner surface of a protector 60. The C-rings 70 fix the protector 60 to the metal pipe 15 and the casing 16. The C-rings 70 are examples of the first fixing member and the second fixing member provided. As illustrated in FIG. 9, each of the C-rings 70 is formed by processing a metal plate into a C-shape and made of a conductive metal material.

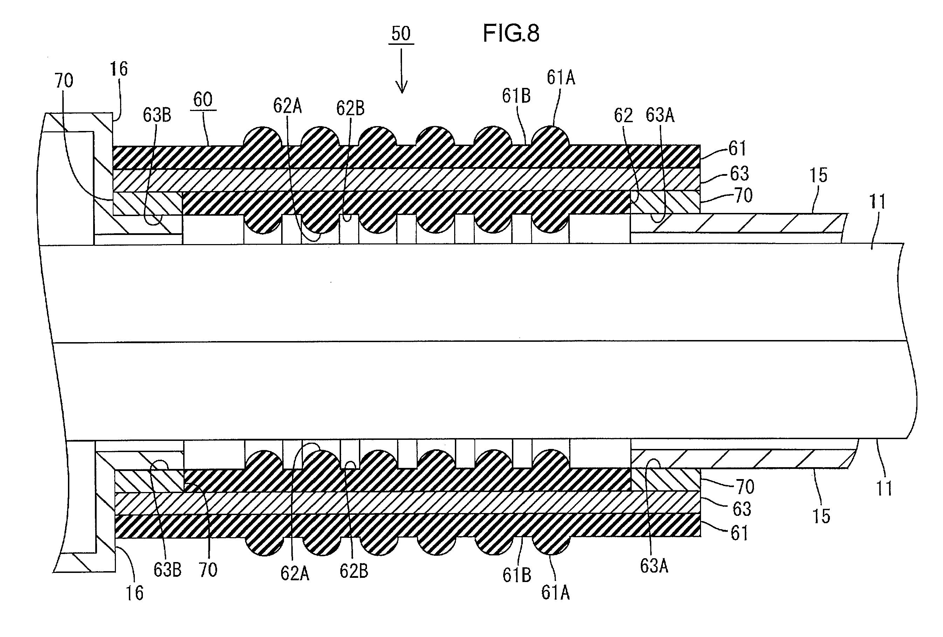

As illustrated in FIG. 8, the C-rings are connected to an inner surface of a shield member 63. More specifically, one of the C-rings 70 is connected to one end portion of the protector 60 (a right end portion in FIG. 8) that corresponds to a first connecting portion 63A and the other one of the C-rings 70 is connected to the other end portion of the protector 60 (a left end portion in FIG. 8) that corresponds to a second connecting portion 63B. One of the two C-rings that is connected to the one end portion corresponding to the first connecting portion 63A is a first C-ring 70A (an example of the first fixing member) and the other C-ring that is connected to the other end portion corresponding to the second connecting portion 63B is a second C-ring 70B (an example of the second fixing member).

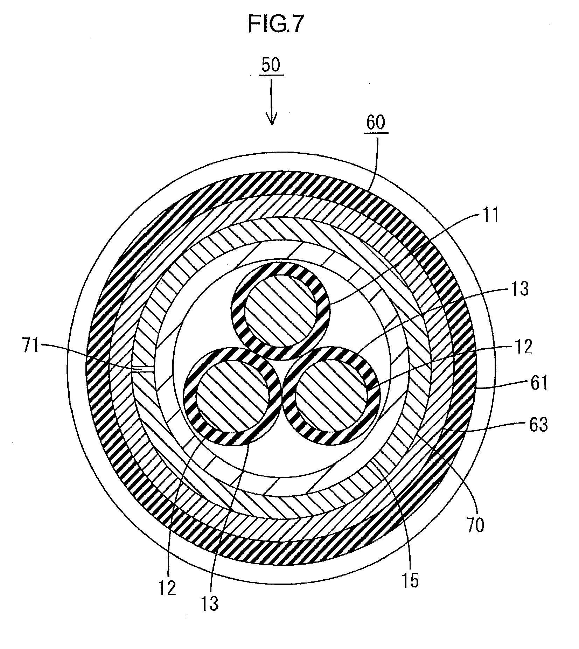

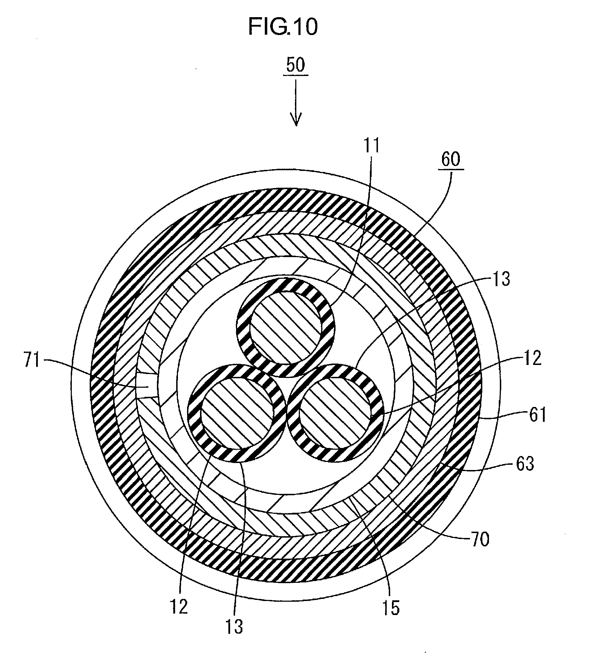

In the second embodiment, the shield conductor 50 is electrically connected to the metal pipe 15 via the first C-ring 70A at the first connecting portion 63A and is electrically connected to the casing 16 via the second C-ring 70B at the second connecting portion 63B. After the protector 60 is fitted to the metal pipe 15 and the casing 16, the first and the second connecting portions 63A and 63B are clamped. As a result, the respective C-rings are firmly fitted to the metal pipe 15 and the casing 16. More specifically, referring to FIG. 10 that illustrates the C-ring 70 before the clamping and FIG. 7 that illustrates the C-ring 70 after the clamping, a gap 71 formed in the C-ring 70 after the clamping is smaller than the gap 71 formed in the C-ring 70 before the clamping. Namely, a diameter of the C-ring 70 is decreased by the clamping.
FIG. 10 illustrates the first C-ring 70A before the clamping of the metal pipe 15. The second C-ring 70B before the clamping of the casing 16 has a configuration similar to that in FIG. 10. FIG. 7 illustrates the first C-ring 70A after the clamping of the metal pipe 15. The second C-ring 70B after the clamping of the casing 16 has a configuration similar to that in FIG. 7.

Next, one example of a process of manufacturing the shield conductor 50 of the second embodiment will be explained. However, the process of manufacturing the shield conductor 50 is not limited to the followings.

First, the first and the second C-rings 70A and 70B are connected by welding to the end portions 63A and 63B of the inner surface of the tubular shield member 63, respectively. Next, the shield member 63 is molded such that an outer layer member 61 made of rubber is formed on an entire outer surface area of the shield member 63 and an inner layer member 62 made of rubber is formed on a portion of the inner surface of the shield member 63 except the portions to which the C-rings 70 are provided. This provides the protector 60 having the two C-rings 70A and 70B provided at the respective end portions 63A and 63B of the inner surface of the shield member 63.

Then, the electric wires 11 are passed through inside the metal pipe 15 and the obtained protector 60. After the electric wires 11 are connected to the device provided in the casing 16, the protector 60 is fitted to the end portion of the casing 16 in which the wires 11 are connected to the device. Consequently, the protector 60 is arranged to extend from the end portion of the pipe 15 to the end portion of the casing 16.

Next, a portion of the protector 60 that corresponds to the first connecting portion 63A is clamped from outside by a known jig. This deforms the first C-ring 70A and decreases the diameter of the first C-ring 70A. Accordingly, the protector 60 and the metal pipe 15 are firmly fixed to each other by the first C-ring 70A (refer to FIGS. 7 and 10). Similarly, a portion of the protector 60 that corresponds to the second connecting portion 63B is clamped from outside by a known jig. This deforms the second C-ring 70B and decreases the diameter of the second C-ring 70B. Accordingly, the protector 60 and the casing 16 are firmly fixed to each other by the second C-ring 70B, resulting such a state, the outer peripheral surface of the metal pipe 15 is in contact with the first C-ring 70A that is connected to the shield member 63 and the outer peripheral surface of the casing 16 is in contact with the second C-ring 70B that is connected to the shield member 63. Accordingly, the shield member 63 is electrically connected to the metal pipe 15 in the first connecting portion 63A and the shield member 63 is electrically connected to the casing 16 in the second connecting portion 63B. Configurations other than the above are similar to those in the first embodiment.

The operations and the effects of this embodiment will be explained.
In the present embodiment, the protector 60 includes the tubular outer layer member 61 made of flexible insulation and the tubular flexible shield member 63 made of a conductive material. The outer layer member 61 is arranged to extend from the first connecting portion 63A to the second connecting portion 63B. The first connecting portion 63A is connected to the metal pipe 15 and the second connecting portion 63B is connected to the casing 16. The shield member 63 is provided on the inner surface of the outer layer member 61 so as to be integral with each other. According to the present embodiment, same as the first embodiment, the electric wire 11 including the connecting portion connected to the device can be protected only by fitting the protector 60 to the electric wire 11 that are connected to the device in the casing 16 and passed through the metal pipe 15. Further, according to the present embodiment, only by attaching the protector 60 to the electric wires 11, the electrical connection is established between the first connecting portion 63A of the shield member 63 and the metal pipe 15 and between the second connecting portion 63B of the shield member 63 and the casing 16. This simplifies a work of attaching a member for the electromagnetic shielding and electric wire protection.

According to the present embodiment, the tubular inner layer member 62 made of flexible insulation is provided to integrally sandwich the shield member 63 included in the protector 60 with the outer layer member 61. The inner layer member 62 is arranged on the inner surface of the shield member 63 excluding the inner surface of the shield member 63 corresponding to the first and the second connecting portions 63A and 63B. With such a configuration, the shield member 63 is less likely to catch on the electric wires 11 or a terminal connected to the electric wires 11. Therefore, the protector 60 can be easily attached and the inner surface of the shield member 63 can be protected.

According to the present embodiment, the first C-ring 70A and the second C-ring 70B are fitted to the portions of the protector 60 corresponding to the first connecting portion 63A and the second connecting portion 63B, respectively. This ensures the electrical connection between the shield member 63 and the metal pipe 15 and between the shield member 63 and the casing 16.

In the second embodiment, the C-rings 70 are connected to the inner surface of the shield member 63 in the protector 60. Therefore, the protector 60 and the fixing members 70 are provided as a single member. Further, when manufacturing the protector 60, masking of the shield member 63 is not necessary and it is not necessary to scrape off a portion of a rubber member to obtain the inner layer member 62.

Further, according to the present embodiment, the outer layer member 61 is made of rubber. Therefore, the first connecting portion 63A is pressed to the end portion of the metal pipe 15 due to the elasticity of the outer layer member 61 and the connection between the shield member 63 and the metal pipe 15 can be secured. The second connecting portion 63B is pressed to the end portion of the casing 16 due to the elasticity of the outer layer member 61 and the connection between the shield member 63 and the casing 16 can be secured. Furthermore, according to the present embodiment, the inner layer member 62 is made of rubber, and this ensures the connection between the protector 60 and the metal pipe 15 and between the protector 60 and the casing 16.

### <Other embodiments>

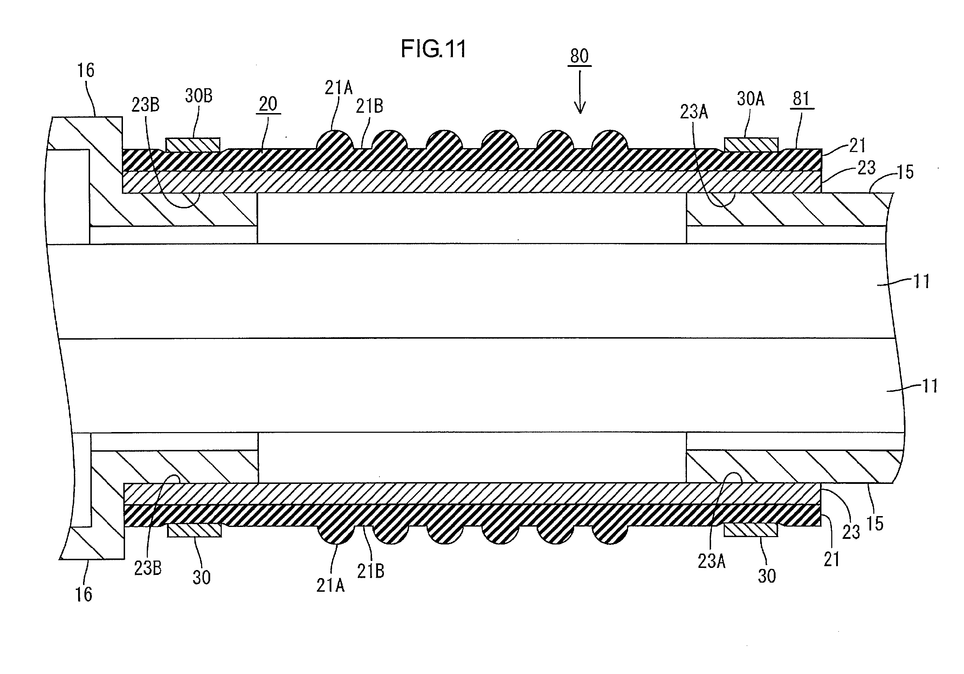

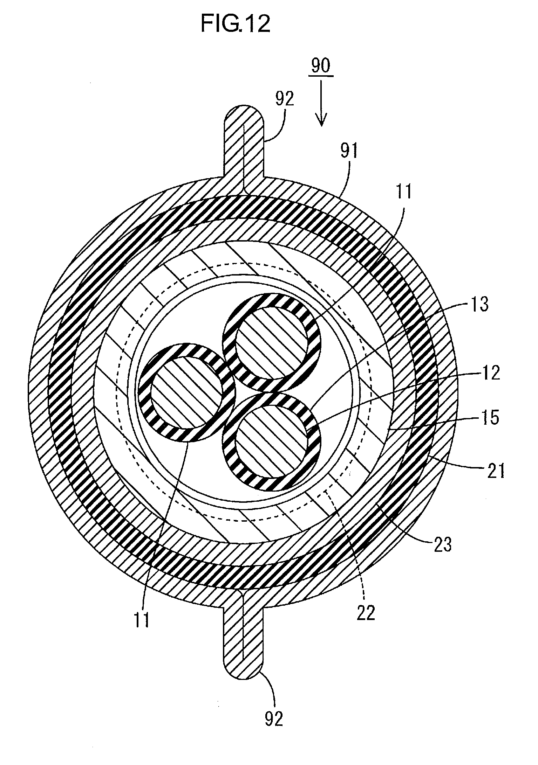

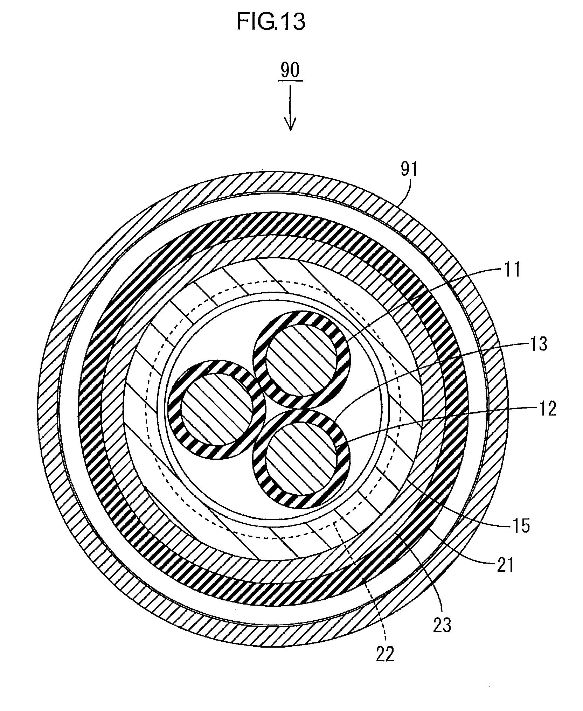

The present invention is not limited to the embodiments explained in the above description with reference to the drawings. The following embodiments may be included in the technical scope of this invention, for example.
(1) In the above embodiments, the protector 20 includes the inner layer member 22. However, the inner layer member 22 may not be included in a protector like a protector 81 illustrated in FIG. 11. A shield conductor 80 in FIG. 11 has the same configuration as the shield conductor 10 of the first embodiment except that the protector 81 does not include the inner layer member 22. In FIG. 11, the same parts as those in the first embodiment are indicated by the same symbols.
(2) In the above embodiments, the clamp bands 30 and the C-rings 70 are used as the first and the second fixing members. However, as illustrated in FIG. 13, a ring-like fixing member 91 that has a circumference greater than an outer circumference of the protector 20 may be used as the first and second fixing members.
As illustrated in FIG. 12, a part of the ring-like fixing member 91 in FIG. 13 is clamped by a jig and deformed to reduce a diameter of the fixing member 91. Accordingly, the protector 20 is firmly fixed to the metal pipe 15 and the casing 16. In FIG. 12, symbols 92 describe clamped portions 92 that are clamped by a known jig. The shield conductor 90 in FIGS. 12 and 13 has the same configuration as the first embodiment except for the configuration of the fixing member 91. In FIG. 12, the same parts as those in the first embodiment are indicated by the same symbols.
(3) In the above embodiments, the first and the second fixing members are provided for the respective first and the second connecting portions, respectively. However, the fixing member may be provided for only one of the connecting portions.
(4) In the above embodiments, the outer and inner layer members 21 and 22 are made of rubber. However, the material may not necessarily be rubber and may be any flexible insulation materials.

### EXPLANATION OF SYMBOLS

10, 50, 80, 90: shield conductor, 11: electric wire, 15: metal pipe, 16: casing, 20, 60, 81: protector, 21, 61: outer layer member, 22, 62: inner layer member, 23, 63: shield member, 23A, 63A: one end portion (first connecting portion), 23B, 63B: another end portion (second connecting portion), 30A, 70A, 91A: first fixing member, 30B, 70B, 91B: second fixing member.

## Claims

1. A shield conductor comprising:
an electric wire configured to be connected to a device provided in a casing;
a metal pipe surrounding the electric wire; and
a tubular protector covering an area from an end portion of the metal pipe to an end portion of the casing, the protector including:
a tubular outer layer member arranged to extend from a first connecting portion to a second connecting portion, the outer layer member being made of flexible insulation, and the first connecting portion connected to the metal pipe and the second connecting portion configured to be connected to the casing, and
a tubular flexible shield member arranged along an inner surface of the outer layer member and provided integrally with the outer layer member, the shield member being made of a conductive material and electrically connected to the metal pipe at the first connecting portion of the protector and configured to be electrically connected to the casing at the second connecting portion of the protector.

2. The shield conductor according to claim 1, further comprising:
a tubular inner layer member made of flexible insulation and provided on an inner surface of the shield member excluding parts of the inner surface of the shield member corresponding to the first connecting portion and the second connecting portion, the inner layer member and the outer layer member sandwiching the shield member so as to be integral with each other.

3. The shield conductor according to one of claims 1 and 2, wherein a first fixing member is fitted to a portion of the protector corresponding to the first connecting portion so as to fix the protector to the metal pipe and a second fixing member is fitted to a portion of the protector corresponding to the second connecting portion so as to fix the protector to the casing.

4. The shield conductor according to claim 3, wherein at least one of the first and the second fixing members is provided on the inner surface of the shield member of the protector.

5. The shield conductor according to any one of claims 1 to 4, wherein the outer layer member is made of rubber.

6. The shield conductor according to any one of claims 2 to 5, wherein the inner layer member is made of rubber.
